# EUROPÄISCHE PATENTSCHRIFT

(11) **EP 3 144 982 B1**
(45) Veröffentlichungstag und Bekanntmachung des Hinweises auf die Patenterteilung: **15.05.2024**
(21) Anmeldenummer: 16001926.1
(22) Anmeldetag: 02.09.2016
(51) Int. Cl.: H01L 31/0687, H01L 31/0693, H01L 31/0304, H01L 31/02

(54) **SKALIERBARE SPANNUNGSQUELLE**
SCALABLE VOLTAGE SOURCE
SOURCE DE TENSION ÉCHELONNABLE

(30) Priorität: 19.09.2015 DE 102015012007
(43) Veröffentlichungstag der Anmeldung: 22.03.2017
(73) Patentinhaber: AZUR SPACE Solar Power GmbH, 74072 Heilbronn (DE)
(72) Erfinder: Fuhrmann, Daniel, 74081 Heilbronn (DE); Khorenko, Victor, 74196 Neuenstadt a.K. (DE); Guter, Wolfgang, 70190 Stuttgart (DE)
(74) Vertreter: Koch Müller Patentanwaltsgesellschaft mbH

(56) Entgegenhaltungen:
- EP-A1- 3 096 361
- EP-A1- 3 104 422
- WO-A1-2012/104421
- CN-A- 102 651 416
- DE-B3-102015 007 326
- JP-A- 2008 177 212
- US-A1- 2006 048 811
- US-A1- 2012 266 803
- US-A1- 2015 162 478
- US-A1- 2015 221 803
- VALDIVIA CHRISTOPHER E ET AL: "Five-volt vertically-stacked, single-cell GaAs photonic power converter", PROCEEDINGS OF SPIE, Bd. 9358, 16. März 2015 (2015-03-16), Seiten 93580E-1-93580E-8, XP060049977, DOI: 10.1117/12.2079824 ISBN: 978-1-62841-730-2
- SCHUBERT J ET AL: "High-Voltage GaAs Photovoltaic Laser Power Converters", IEEE TRANSACTIONS ON ELECTRON DEVICES, IEEE SERVICE CENTER, PISACATAWAY, NJ, US, Bd. 56, Nr. 2, 28. Januar 2009 (2009-01-28), Seiten 170-175, XP011241423, ISSN: 0018-9383, DOI: 10.1109/TED.2008.2010603
- ANDREAS W. BETT ET AL: "III-V solar cells under monochromatic illumination", 2008 33RD IEEE PHOTOVOLATIC SPECIALISTS CONFERENCE, 1 May 2008 (2008-05-01), pages 1-5, XP055103509, ISSN: 0160-8371, DOI: 10.1109/PVSC.2008.4922910 ISBN: 978-1-42-441640-0
- WILKINS MATTHEW ET AL: "Performance impact of luminescent coupling on monolithic 12-junction phototransducers for 12 V photonic power systems", PROCEEDINGS OF SPIE; [PROCEEDINGS OF SPIE ISSN 0277-786X VOLUME 10524], SPIE, US, vol. 9743, 14 March 2016 (2016-03-14), pages 97430W-97430W, XP060067383, DOI: 10.1117/12.2213727 ISBN: 978-1-5106-1533-5

## Beschreibung

Die Erfindung betrifft eine skalierbare Spannungsquelle.

Aus der US 4 127 862, der US 6 239 354 B1, der DE 10 2010 001 420 A1, aus Nader M. Kalkhoran, et al, "Cobalt disilicide intercell ohmic contacts for multijunction photovoltaic energy converters", Appl. Phys. Lett. 64, 1980 (1994) und aus A. Bett et al, "III-V Solar cells under monochromatic illumination", Photovoltaic Specialists Conference, 2008, PVSC '08. 33rd IEEE, Seite 1-5, ISBN:978-1-4244-1640-0 sind skalierbare Spannungsquellen oder auch Solarzellen aus III-V Materialien bekannt. Auch aus Valdivia Christopher et al; "Five-volt vertically-stacked, single-cell GaAs photonic power converter" proceedings of Spie, bd. 9358, 16. März 2015, Seiten 1 -8, ISBN 978-1-62841-730-2, der US 2006 / 048811 A1, der WO 2014 / 096200 A1, der US 2015 / 0162478 A1, der nach veröffentlichten EP 3 096 361 A (Stand der Technik nach Art. 54 (3) EPÜ) und Schubert et al, "High-Voltage GaAs Photovoltaic Laser Power Converters", IEEE Transactions on electronic devices, Bd 56, Nr. 2 Februar 2009, Seiten 170-175, ISSN: 0018-9383 sind gattungsgemäße Spannungsquellenanordnungen bekannt.

Weitere skalierbare Spannungsquellen sind aus der CN 102 651 416 A, der US 2012/266 803 A1, der WO 2012/104 421 A1, der US 2015/221 803 A1 sowie aus Andreas W. Bett et al: "III-V solar cells under monochromatic illumination", 33rd IEEE Photovoltaic Specialists Conference, Mai 2008, S. 1-5, XP055103509, ISSN: 0160-8371, DOI: 10.1109/PVSC.2008.4922910, ISBN: 978-1-42-441640-0 bekannt.

Auch aus der JP 2008 177212 A sind optische Bauelemente bekannt.

Vor diesem Hintergrund besteht die Aufgabe der Erfindung darin, eine Vorrichtung anzugeben, die den Stand der Technik weiterbildet.

Die Aufgabe wird durch eine skalierbare Spannungsquelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird skalierbare Spannungsquelle aufweisend eine Anzahl N zueinander in Serie geschalteten als Halbleiterdioden ausgebildete Teilspannungsquellen bereitgestellt, wobei jede der Teilspannungsquellen eine Halbleiterdiode mit einen p-n Übergang aufweist, und die Halbleiterdiode eine p-dotierte Absorptionsschicht aufweist, wobei die p-Absorptionsschicht von einer p-dotierten Passivierungsschicht mit einer größeren Bandlücke als die Bandlücke der p-Absorptionsschicht passiviert ist und die Halbleiterdiode eine n-Absorptionsschicht aufweist, wobei die n-Absorptionsschicht von einer n-dotierten Passivierungsschicht mit einer größeren Bandlücke als die Bandlücke der n-Absorptionsschicht passiviert ist, und die Teilquellenspannungen der einzelnen Teilspannungsquellen zueinander einer Abweichung kleiner als 20% aufweisen, und zwischen jeweils zwei aufeinanderfolgenden Teilspannungsquellen eine Tunneldiode ausgebildet ist, wobei die Tunneldiode mehrere Halbleiterschichten mit einer höheren Bandlücke als die Bandlücke der p / n Absorptionsschichten aufweist und die Halbleiterschichten mit der höheren Bandlücke jeweils aus einem Material mit geänderter Stöchiometrie und / oder anderer Elementzusammensetzung als die p / n -Absorptionsschichten der Halbleiterdiode bestehen, und die Teilspannungsquellen und die Tunneldioden zusammen monolithisch integriert sind, und gemeinsam einen ersten Stapel mit einer Oberseite und einer Unterseite ausbilden, und die Anzahl N der Teilspannungsquellen genau gleich zwei ist, und das Licht an der Oberseite auf den ersten Stapel auftrifft und die Größe der Beleuchtungsfläche an der Stapeloberseite im Wesentlichen der Größe der Fläche des ersten Stapels an der Oberseite ist, und der erste Stapel eine Gesamtdicke kleiner als 12 µm aufweist, und bei 300 K der erste Stapel eine Quellenspannung von größer als 2,2 Volt aufweist, sofern der erste Stapel mit einem Photonenstrom bestrahlt ist, und wobei in Lichteinfallsrichtung von der Oberseite des ersten Stapels hin zu der Unterseite des ersten Stapels die Gesamtdicke der p und n -Absorptionsschichten einer Halbleiterdiode von der obersten Halbleiterdiode hin zu der untersten Halbleiterdiode zunimmt und in der Nähe der Unterseite des ersten Stapels eine umlaufende Stufe ausgebildet und die Höhe der Stufe größer als 100nm ist.

Es sei angemerkt, dass mit dem Ausdruck wesentlich in Zusammenhang des Vergleichs der Beleuchtungsfläche an der Stapeloberseite mit der Größe der Fläche des ersten Stapels an der Oberseite verstanden wird, einen Unterschied in der Fläche insbesondere kleiner als 20% oder vorzugsweise kleiner als 10% oder vorzugsweise kleiner als 5% oder höchst vorzugsweise die beiden Flächen gleich sind.

Auch sei angemerkt, dass mit dem Ausdruck "Licht" zur Bestrahlung der Stapeloberseite, ein Licht verstanden wird, welches ein Spektrum an Wellenlängen in dem Bereich der Absorption der Absorptionsschichten aufweist. Es versteht sich, dass auch ein monochromatisches Licht, welches eine bestimmte d.h. absorbierende Wellenlänge aufweist, also eine Wellenlänge in dem Bereich der Absorption der Absorptionsschichten, geeignet ist.

Es versteht sich, dass die vorzugsweise die gesamte Oberseite des ersten Stapels d.h. die gesamte oder nahezu die gesamte Oberfläche mit Licht einer bestimmten Wellenlänge bestrahlt wird. Es sei angemerkt, dass eingehende Untersuchungen in überraschender Weise zeigten, dass im Unterschied zu dem Stand der Technik sich in vorteilhafter Weise mit dem vorliegenden monolithischen Stapelansatz Quellenspannungen oberhalb von 2,2V ergeben. Es sei angemerkt, dass im Folgenden die Begriffe Diode und Halbleiterdiode synonym verwendet werden.

Ein Vorteil der erfindungsgemäßen Vorrichtung ist es, dass durch die Hintereinanderschaltung von einer Vielzahl von Teilspannungsquellen eine Spannungsquelle mit Spannungswerten auch oberhalb von drei oder mehr Volt sich mittels eines monolithisch integrierten Aufbau eine einfache und kostengünstige sowie eine zuverlässige Spannungsquelle herstellen lässt. Ein weiterer Vorteil ist, dass mittels der stapelförmigen Anordnung im Vergleich zu der bisherigen lateralen Anordnung mit Siliziumdioden eine große Flächeneinsparung ergibt. Insbesondere muss von der Sendediode oder der Lichtquelle nur die wesentlich kleinere Empfangsfläche des Stapels beleuchtet werden.

In einer Weiterbildung weicht die Teilquellenspannungen der einzelnen Teilspannungsquellen untereinander weniger als 10% ab. Hierdurch wird die Einsetzbarkeit als skalierbare Spannungsquelle insbesondere als Referenzspannungsquelle wesentlich verbessert. Es versteht sich, dass sich der Begriff der "Skalierbarkeit" auf die Höhe der Quellenspannung des gesamten Stapels bezieht.

In einer anderen Weiterbildung weisen die Halbleiterdioden jeweils das gleiche Halbleitermaterial auf, wobei hierbei das Halbleitermaterial der Dioden die gleiche kristalline Zusammensetzung aufweist und vorzugsweise die Stöchiometrie nahezu oder vorzugsweise genau gleich ist. Auch ist es vorteilhaft, den ersten Stapel auf einem Substrat anzuordnen. In einer Ausführungsform besteht das Halbleitermaterial und / oder das Substrat aus III-V Materialien. Insbesondere ist bevorzugt, dass das Substrat Germanium oder Galliumarsenid umfasst und / oder die Halbleiterschichten auf dem Substrat Arsen und / oder Phosphor aufweisen. Anders ausgedrückt umfassen die Halbleiterschichten Ashaltige Schichten und P -haltige Schichten, d.h. Schichten aus GaAs oder Al-GaAs oder InGaAs als Beispiele für Arsenid-Schichten und InGaP als ein Beispiel für Phosphid-Schichten.

Erfindungsgemäß ist auf der Unterseite des ersten Stapels ein zweiter Spannungsanschluss ausgebildet, sodass der zweite Spannungsanschluss durch das Substrat ausgebildet ist.

In einer anderen Ausführungsform bestehen die Halbleiterdioden aus dem gleichen Material wie das Substrat. Ein Vorteil ist, dass sich dann insbesondere die Ausdehnungskoeffizienten der beiden Teile gleichen. Es ist vorteilhaft, wenn die Halbleiterdioden grundsätzlich aus einem III-V Material bestehen. Insbesondere ist es bevorzugt, GaAs zu verwenden.

Erfindungsgemäß ist auf der Oberseite des ersten Stapels ein erster Spannungsanschluss als ein umlaufender Metallkontakt in der Nähe des Randes oder als einzelne Kontaktfläche an dem Rand ausgebildet.

Des Weiteren ist es bevorzugt, wenn der erste Stapel eine Grundfläche kleiner als 2 mm² oder kleiner als 1 mm² aufweist. Untersuchungen haben gezeigt, dass es vorteilhaft ist, die Grundfläche viereckig auszubilden. Vorzugsweise ist die Grundfläche des Stapels quadratisch ausgebildet.

Weitere Untersuchungen haben gezeigt, dass um besonderes hohe Spannungen zu erzielen, es vorteilhaft ist, einen zweiten Stapel auszubilden und die beiden Stapel miteinander in Serie zu verschalten, so dass sich die Quellenspannung des ersten Stapels und die Quellenspannung des zweiten Stapels addieren. Vorzugsweise sind der erste Stapel und der zweite Stapel nebeneinander auf einem gemeinsamen Träger angeordnet.

In einer Weiterbildung weicht die Quellenspannung des ersten Stapels von der Quellenspannung des zweiten Stapels um weniger als 15 % ab.

Des Weiteren ist es bevorzugt, dass unterhalb der untersten Halbleiterdiode des Stapels ein Halbleiterspiegel ausgebildet ist. Untersuchungen haben gezeigt, dass sich eine Vielzahl von Stapeln nebeneinander auf einem Halbleiterwafer oder Halbleitersubstratscheibe ausbilden lassen, indem nach der ganzflächigen, vorzugsweise epitaktischen Herstellung der Schichten, eine sogenannte Mesaätzung durchgeführt wird. Hierzu wird mittels eines Maskenprozesses eine Lackmaske erzeugt und anschließend vorzugsweise eine nasschemische Ätzung zur Erzeugung von Mesa-Gräben durchgeführt. Die Mesaätzung stoppt vorzugsweise in dem Substrat oder auf dem Substrat.

In einer Weiterbildung ist es bevorzugt, dass jeder Stapel in der Nähe der Unterseite einen umlaufenden, absatzförmigen Rand aufweist, wobei bei zwei unmittelbar benachbarten Stapeln an den Außenseiten des Stapelgebildes der umlaufende Rand als ein gemeinsamer umlaufender Rand ausgebildet ist, so dass die Spannungsquelle einen umlaufenden Rand aufweist.

Erfindungsgemäß ist der Rand stufenförmig oder als Stufe ausgebildet. Hierbei weist die Oberfläche des Randes bzw. der Stufe vorzugsweise größtenteils eine plane Fläche auf, wobei die Normale der Oberfläche des Randes bzw. der Stufe parallel oder nahezu parallel zu der Normalen der Oberfläche des ersten Stapels oder der Normalen der Oberflächen der jeweiligen Stapel ausgebildet ist. Es sei angemerkt dass die Seitenfläche des Randes oder der Stufe überwiegend oder genau senkrecht zu der Oberfläche des Randes bzw. der Stufe ausgebildet ist. Die Höhe der Stufe ist größer als 100 nm, d.h. die umlaufende Seitenfläche hat eine Höhe von größer als 100 nm, um eine ausreichende mechanische Stabilität zu erreichen. Insbesondere weist die Stufe eine Höhe kleiner als 1000 µm auf.

Die Kante des Randes oder der Stufe ist wenigstens 5 µm und maximal 500 µm jeweils von jeder der vier Seitenflächen des ersten Stapels oder jeweils von den Seitenflächen der mehreren Stapeln entfernt. Vorzugsweise liegt der Entfernungsbereich jeweils der Kante zu der unmittelbar angrenzenden Seitenfläche zwischen 10 µm und 300 µm. Insbesondere liegt der Entfernungsbereich zwischen 50 µm und 250 µm.

Vorzugsweise sind die Seitenflächen des ersten Stapels und insbesondere alle Seitenflächen der Stapel plan und insbesondere senkrecht oder nahezu senkrecht ausgebildet. Insbesondere liegen die Normalen auf Seitenflächen im Vergleich zu den Normalen der angrenzenden Randflächen oder den Normalen der Stapeloberflächen in einen Winkelbereich zwischen 80° und 110°, d.h. die Normalen einer Seitenfläche und der unmittelbar angrenzenden Randfläche sind zueinander im Wesentlichen Orthogonal. Vorzugsweise liegt der Winkelbereich zwischen 85° und 105°.

In einer Weiterbildung ist zwischen der p Absorptionsschicht und der n-Absorptionsschicht bei mindestens einer Halbleiterdiode eine intrinsische Schicht ausgebildet. In einer Ausführungsform ist die intrinsische Schicht bei der untersten Halbleiterdiode ausgebildet. In einer anderen Weiterbildung ist die intrinsische Schicht bei allen Halbleiterdiode ausgebildet. Hierbei wird unter einer intrinsischen Schicht eine Halbleiterschicht mit einer Dotierung unterhalb 1E16 1/cm³, vorzugsweise kleiner als 5E15 1/cm³, höchst vorzugsweise kleiner als 1,5 E15 1/cm³ verstanden.

In einer Ausführungsform sind auf einem Germanium-Substrat genau zwei Halbleiterdioden angeordnet, wobei die Halbleiterdioden jeweils als Absorptionsmaterial eine zu dem Ge-Substrat gitterangepasste InGaAs Verbindung umfassen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine erste erfindungsgemäße Ausführungsform einer skalierbaren Spannungsquelle mit einem Stapel und zwei Teilspannungsquellen,
- Figur 2: eine zweite Ausführungsform einer skalierbaren Spannungsquelle mit mehreren Stapeln mit je zwei Teilspannungsquellen,
- Figur 3: eine dritte nicht erfindungsgemäße Ausführungsform einer skalierbaren Spannungsquelle mit einem Stapel mit drei Teilspannungsquellen,
- Figur 4: eine vierte nicht erfindungsgemäße Ausführungsform einer skalierbaren Spannungsquelle mit mehreren Stapeln mit je drei Teilspannungsquellen,
- Figur 5: eine nicht erfindungsgemäße Ausführungsform mit insgesamt fünf Dioden mit unterschiedlicher Dicke des Absorptionsgebiets,
- Figur 6: eine Stapel mit einer umlaufenden absatzförmigen Stufe.

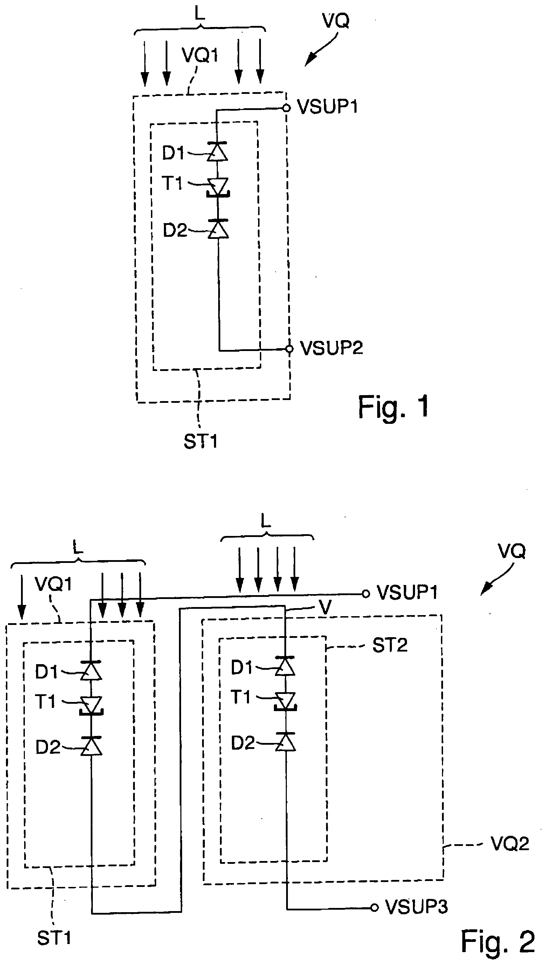

Die Abbildung der Figur 1 zeigt eine schematische Ansicht einer ersten Ausführungsform mit zwei Teilspannungsquellen, aufweisend eine skalierbare Spannungsquelle VQ mit einem ersten Stapel ST1 mit einer Oberseite und einer Unterseite mit einer Anzahl N gleich zwei Dioden. Der erste Stapel ST1 weist eine Serienschaltung aus einer ersten Diode D1 und einer ersten Tunneldiode T1 und einer zweiten Diode D2 auf. An der Oberseite des Stapel ST1 ist ein erster Spannungsanschluss VSUP1 und der Unterseite des Stapel ST1 ein zweiter Spannungsanschluss VSUP2 ausgebildet. Die Quellenspannung VQ1 des ersten Stapel ST1 setzt sich vorliegend aus den Teilspannungen der einzelnen Dioden D1 bis D2 zusammen. Hierzu ist der erste Stapel ST1 einem Photonenstrom, d.h. dem Licht L ausgesetzt.

Der erste Stapel ST1 der Dioden D1 bis D2 und der Tunneldiode T1 ist als monolithisch ausgebildeter Block, vorzugsweise aus dem gleichen Halbleitermaterial, ausgeführt.

In der Abbildung der Figur 2 ist eine weitere Ausführungsform einer vorteilhaften Aneinanderreihung von dem ersten Stapel ST1 und einem zweiten Stapel ST2 ausgebildet. Beide Stapel ST1 und ST2 weisen jeweils zwei Teilspannungsquellen auf. Im Folgenden werden nur die Unterschiede zu der Abbildung der Figur 1 erläutert. Der zweite Stapel ST2 weist wie der erste Stapel ST1 eine Serienschaltung aus zwei Dioden mit dazwischen ausgebildeten Tunneldioden auf. Beide Stapel ST1 und ST2 sind miteinander in Serie verschaltet, sodass sich die Quellenspannung VQ1 des ersten Stapels ST1 und die Quellenspannung VQ2 des zweiten Stapel ST2 addieren, sofern die beiden Stapel ST1 und ST2 dem Photonenstrom L ausgesetzt sind.

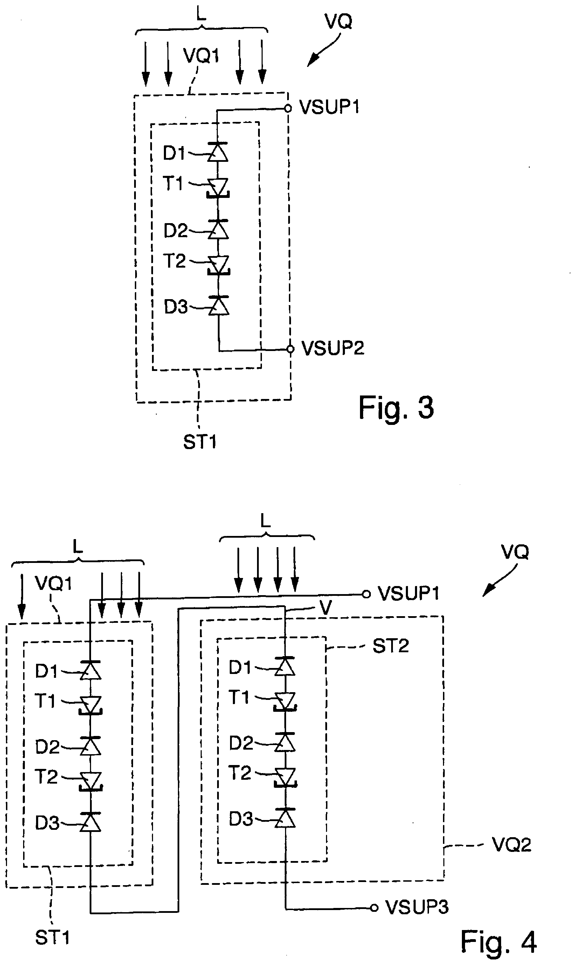

Die Abbildung der Figur 3 zeigt eine schematische Ansicht einer ersten nicht erfindungsgemäßen Ausführungsform mit drei Teilspannungsquellen, aufweisend die skalierbare Spannungsquelle VQ mit dem ersten Stapel ST1 mit der Oberseite und der Unterseite mit der Anzahl N gleich drei Dioden. Der erste Stapel ST1 weist die Serienschaltung aus der ersten Diode D1 und der ersten Tunneldiode T1 und der zweiten Diode D2 und einer zweiten Tunneldiode T2 und einer dritten Diode D3 auf. An der Oberseite des Stapel ST1 ist der erster Spannungsanschluss VSUP1 und der Unterseite des Stapel ST1 der zweiter Spannungsanschluss VSUP2 ausgebildet. Die Quellenspannung VQ1 des ersten Stapel ST1 setzt sich vorliegend im Wesentlichen aus den Teilspannungen der einzelnen Dioden D1 bis D3 zusammen. Hierzu ist der erste Stapel ST1 dem Photonenstrom, d.h. dem Licht L ausgesetzt.

Der erste Stapel ST1 der Dioden D1 bis D3 und der Tunneldioden T1 und T2 ist als monolithisch ausgebildeter Block, vorzugsweise aus dem gleichen Halbleitermaterial, ausgeführt.

In der Abbildung der Figur 4 ist eine weitere nicht erfindungsgemäße Ausführungsform einer vorteilhaften Aneinanderreihung von dem ersten Stapel ST1 und dem zweiten Stapel ST2 ausgebildet. Vorliegend weisen beide Stapel ST1 und ST2 jeweils drei Teilspannungsquellen auf.

Im Folgenden werden nur die Unterschiede zu der Abbildung der Figur 3 erläutert. Der zweite Stapel ST2 weist wie der erste Stapel ST1 eine Serienschaltung aus drei Dioden mit dazwischen ausgebildeten Tunneldioden auf. Beide Stapel ST1 und ST2 sind miteinander in Serie verschaltet, sodass sich die Quellenspannung VQ1 des ersten Stapels ST1 und die Quellenspannung VQ2 des zweiten Stapel ST2 addieren, sofern die beiden Stapel ST1 und ST2 dem Photonenstrom L ausgesetzt sind.

In einer nicht dargestellten Ausführungsform weisen die beiden Stapel ST1 und ST2 zueinander eine unterschiedliche Anzahl von jeweils in einer Serienschaltung verbundenen Dioden auf. In einer anderen nicht dargestellten Ausführungsform weist wenigstens der erste Stapel ST1 und / oder der zweite Stapel ST2 mehr als drei in einer Serienschaltung verbundene Dioden auf. Hierdurch lässt sich die Spannungshöhe der Spannungsquelle VQ skalieren. Vorzugsweise liegt die Anzahl N in einem Bereich zwischen vier und acht. In einer Weiteren nicht dargestellten Ausführungsform, sind die beiden Stapel ST1 und ST2 zueinander parallel geschaltet.

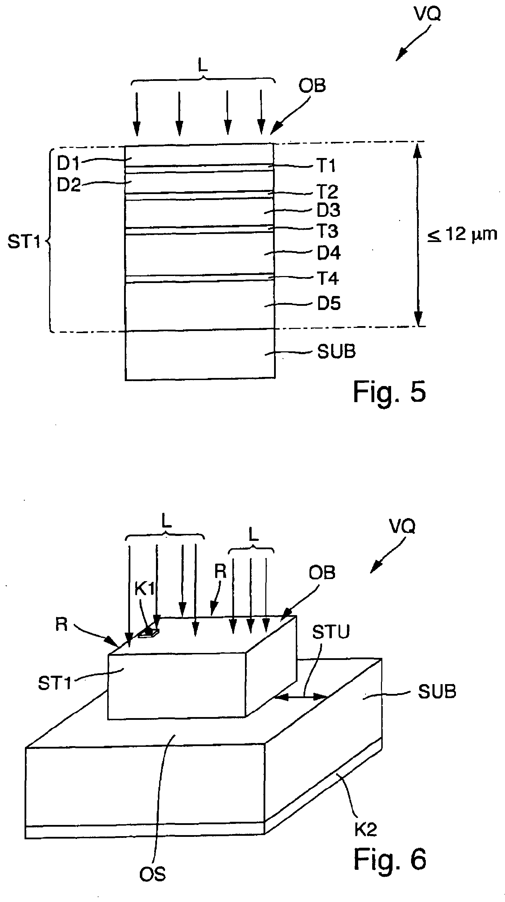

In der Abbildung der Figur 5 ist eine nicht erfindungsgemäße Ausführungsform einer vorteilhaften Aneinanderreihung von Halbleiterschichten zu dem ersten Stapel ST1 dargestellt. Im Folgenden werden nur die Unterschiede zu der Abbildung der Figur 1 erläutert. Der erste Stapel ST1 umfasst insgesamt fünf in Reihe geschaltete als Dioden D1 bis D5 ausgebildete Teilspannungsquellen. Auf die Oberfläche OB der ersten Diode D1 trifft das Licht L auf. Die Oberfläche OB wird nahezu oder vollständig ausgeleuchtet. Zwischen zwei aufeinanderfolgenden Dioden D1-D5 ist jeweils eine Tunneldiode T1-T4 ausgebildet. Mit zunehmender Entfernung der einzelnen Diode D1 bis D5 von der Oberfläche OB steigt die Dicke des Absorptionsgebiets, so dass die unterste Diode D5 das dickste Absorptionsgebiet aufweist. Insgesamt beträgt die Gesamtdicke des ersten Stapels ST1 kleiner gleich 12 µm. Unterhalb der untersten Diode D5 ist ein Substrat SUB ausgebildet.

In der Abbildung der Figur 6 ist eine Ausführungsform einer vorteilhaften Aneinanderreihung von Halbleiterschichten zu dem ersten Stapel ST1 dargestellt mit einer umlaufenden absatzförmigen Stufe. Im Folgenden werden nur die Unterschiede zu der Abbildung der Figur 3 erläutert. Auf der Oberfläche OB des ersten Stapels ST1 ist an dem Rand R ein erster metallischer Anschlusskontakt K1 ausgebildet. Der erste Anschlusskontakt K1 ist mit dem ersten Spannungsanschluss VSUP1 verschaltet - nicht dargestellt. Das Substrat SUB weist eine Oberseite OS auf, wobei die Oberseite OS des Substrats SUB stoffschlüssig mit der untersten, z.B. der fünften Diode D5 verbunden ist. Hierbei versteht es sich, dass auf dem Substrat eine dünne Nukleationsschicht und eine Pufferschicht epitaktisch erzeugt wird, bevor auf dem Substrat die unterste Diode angeordnet wird und stoffschlüssig mit der Oberseite OS des Substrats verbunden wird. Die Oberseite OS des Substrats SUB weist eine größere Oberfläche als die Fläche an der Unterseite des ersten Stapels ST1 auf. Hierdurch bildet sich eine umlaufende Stufe STU aus. Die Höhe der Seitenfläche der Stufe STU ist größer als 100nm. Der Rand der Stufe STU ist von der unmittelbar angrenzenden Seitenfläche des ersten Stapels ST1 der Stufe um mehr als 5µm und weniger als 500µm entfernt, dargestellt als Länge des Referenzzeichens STU. An der Unterseite des Substrats SUB ist ein zweiter ganzflächiger metallischer Kontakt K2 ausgebildet. Der zweite Anschlusskontakt K2 ist mit dem zweiten Spannungsanschluss VSUP2 verschaltet - nicht dargestellt.

## Patentansprüche

1. Skalierbare Spannungsquelle (VQ) aufweisend
- eine Anzahl N zueinander in Serie geschalteten als Halbleiterdioden ausgebildete Teilspannungsquellen, wobei jede der Teilspannungsquellen eine Halbleiterdiode (D1, D2) mit einen p-n Übergang aufweist, und die Halbleiterdiode (D1, D2) eine p-dotierte Absorptionsschicht aufweist und die Halbleiterdiode (D1, D2) eine n-Absorptionsschicht aufweist, wobei die n-Absorptionsschicht von einer n-dotierten Passivierungsschicht mit einer größeren Bandlücke als die Bandlücke der n-Absorptionsschicht passiviert ist,
und die Teilquellenspannungen der einzelnen Teilspannungsquellen zueinander einer Abweichung kleiner als 20% aufweisen, und
- zwischen jeweils zwei aufeinanderfolgenden Teilspannungsquellen eine Tunneldiode (T1) ausgebildet ist, wobei
die Tunneldiode (T1) mehrere Halbleiterschichten mit einer höheren Bandlücke als die Bandlücke der p / n Absorptionsschichten aufweist und die Halbleiterschichten mit der höheren Bandlücke jeweils aus einem Material mit geänderter Stöchiometrie und / oder anderer Elementzusammensetzung als die p / n -Absorptionsschichten der Halbleiterdiode (D1, D2) bestehen, und
- die Teilspannungsquellen und die Tunneldioden (T1) zusammen monolithisch integriert sind, und gemeinsam einen ersten Stapel (ST1) mit einer Oberseite und einer Unterseite ausbilden, und die Anzahl N der Teilspannungsquellen genau gleich zwei ist, und
- bei einer Beleuchtung des ersten Stapels (ST1) mit Licht (L) das Licht (L) an der Oberseite auf die Oberfläche (OB) auf den ersten Stapel (ST1) auftrifft und die Größe der beleuchteten Oberfläche (OB) an der Stapeloberseite im Wesentlichen der Größe der Fläche des ersten Stapels an der Oberseite entspricht, und
der erste Stapel (ST1) eine Gesamtdicke kleiner als 12 µm aufweist, und
- bei 300 K der erste Stapel (ST1) eine Quellenspannung (VQ1) von größer als 2,2 Volt aufweist, sofern der erste Stapel (ST1) mit Licht (L) bestrahlt ist, und wobei in Lichteinfallsrichtung von der Oberseite des ersten Stapels (ST1) hin zu der Unterseite des Stapels die Gesamtdicke der p und n -Absorptionsschichten einer Halbleiterdiode von der obersten Halbleiterdiode (D1) hin zu der untersten Halbleiterdiode (D2) zunimmt,
jede p-Absorptionsschicht der Halbleiterdiode (D1, D2) von einer p-dotierten Passivierungsschicht mit einer größeren Bandlücke als die Bandlücke der p-Absorptionsschicht passiviert ist und
- der erste Stapel (ST1) auf einem Substrat (SUB) angeordnet ist und das Substrat (SUB) ein Halbleitermaterial umfasst,
auf der Oberseite des ersten Stapels (ST1) ein erster Spannungsanschluss (VSUP1) als ein umlaufender erster Metallkontakt (K1) in der Nähe des Randes (R) oder als eine einzelne Kontaktfläche (K1) an dem Rand (R) ausgebildet ist ,
- eine Oberseite (OS) des Substrats (SUB) stoffschlüssig mit der untersten Diode verbunden ist,
- die Oberseite (OS) des Substrats (SUB) eine größere Oberfläche als die Fläche an der Unterseite des ersten Stapels ST1 aufweist, so dass sich in der Nähe der Unterseite des ersten Stapels (ST1) eine umlaufende Stufe (STU) ausgebildet und
- ein zweiter Spannungsanschluss (VSUP2) als ein ganzflächiger metallischer Anschlusskontakt K2 an einer Unterseite des Substrats (SUB) ausgebildet ist.

2. Skalierbare Spannungsquelle (VQ) nach Anspruch 1, **dadurch gekennzeichnet, dass** die Teilquellenspannungen der Teilspannungsquellen zueinander einer Abweichung kleiner als 10% aufweisen.

3. Skalierbare Spannungsquelle (VQ) nach Anspruch 1 oder Anspruch 2, **dadurch gekennzeichnet, dass** die Halbleiterdioden (D1, D2) jeweils das gleiche Halbleitermaterial aufweisen.

4. Skalierbare Spannungsquelle (VQ) nach einem der vorangegangenen Ansprüche, **dadurch gekennzeichnet, dass** der erste Stapel (ST1) eine Grundfläche kleiner als 2 mm² oder kleiner als 1 mm² aufweist.

5. Skalierbare Spannungsquelle (VQ) nach Anspruch 4, **dadurch gekennzeichnet, dass** die Grundfläche viereckig ausgebildet ist.

6. Skalierbare Spannungsquelle (VQ) nach einem der vorangegangenen Ansprüche, **dadurch gekennzeichnet, dass** ein zweiter Stapel (ST2) ausgebildet ist und der erste Stapel (ST1) und der zweite Stapel (ST2) nebeneinander auf einem gemeinsamen Träger angeordnet sind und die beiden Stapel (ST1, ST2) miteinander in Serie verschaltet sind, so dass sich die Quellenspannung (VQ1) des ersten Stapels (ST1) und die Quellenspannung (VQ2) des zweiten Stapels (ST2) addieren.

7. Skalierbare Spannungsquelle (VQ) nach einem der vorangegangenen Ansprüche, **dadurch gekennzeichnet, dass** das Halbleitermaterial und / oder das Substrat aus III-V Materialien bestehen.

8. Skalierbare Spannungsquelle (VQ) nach einem der vorangegangenen Ansprüche, **dadurch gekennzeichnet, dass** das Substrat Germanium oder Galliumarsenid umfasst.

9. Skalierbare Spannungsquelle (VQ) nach einem der vorangegangenen Ansprüche, **dadurch gekennzeichnet, dass** unterhalb der untersten Halbleiterdiode des Stapels ein Halbleiterspiegel ausgebildet ist.

10. Skalierbare Spannungsquelle (VQ) nach einem der vorangegangenen Ansprüche, **dadurch gekennzeichnet, dass** die Halbleiterschichten des Stapels (ST1) gleichzeitig Arsenid-haltige Schichten und Phosphidhaltige Schichten umfassen.

11. Skalierbare Spannungsquelle (VQ) nach einem der vorangegangenen Ansprüche, **dadurch gekennzeichnet, dass** die Kante des Randes wenigstens 5 µm und maximal 500 µm von der unmittelbar angrenzenden Seitenfläche der Stapel entfernt ist.

12. Skalierbare Spannungsquelle (VQ) nach einem der vorangegangenen Ansprüche, **dadurch gekennzeichnet, dass** zwischen der p Absorptionsschicht und der n-Absorptionsschicht bei mindestens einer Halbleiterdiode eine intrinsische Schicht ausgebildet ist.

13. Skalierbare Spannungsquelle (VQ) nach Anspruch 12, **dadurch gekennzeichnet, dass** die intrinsische Schicht bei der untersten Halbleiterdiode ausgebildet ist.

14. Skalierbare Spannungsquelle (VQ) nach Anspruch 12, **dadurch gekennzeichnet, dass** die intrinsische Schicht bei allen Halbleiterdioden ausgebildet ist.

15. Skalierbare Spannungsquelle (VQ) nach einem der vorangegangenen Ansprüche, **dadurch gekennzeichnet, dass** die beiden Halbleiterdioden auf einem Germanium-Substrat angeordnet sind und die Halbleiterdioden jeweils als Absorptionsmaterial eine zu dem Ge-Substrat gitterangepasste InGaAs Verbindung aufweisen.

## Claims

1. Scalable voltage source (VQ) comprising
- a number N of component voltage sources connected with one another in series and constructed as semiconductor diodes, wherein each of the component voltage sources comprises a semiconductor diode (D1, D2) with a p-n transition and the semiconductor diode (D1, D2) comprises a p-doped absorption layer and the semiconductor diode (D1, D2) an n-doped absorption layer, wherein the n-absorption layer is passivated by an n-doped passivation layer with a greater band gap than the band gap of the n-absorption layer, and the component source voltages of the individual component voltage sources have a difference of less than 20% from one another and
- a tunnel diode (T1) is formed between each two successive component voltage sources, wherein the tunnel diode (T1) comprises a plurality of semiconductor layers with a higher band gap than the band gap of the p/n absorption layers and the semiconductor layers with the higher band gap each consist of a material with changed stoichiometry and/or a different element composition from the pin absorption layers of the semiconductor diode (D1, D2) and
- the component voltage sources and the tunnel diodes (T1) are integrated together monolithically and together form a first stack (ST1) with an upper side and a lower side, and the number N of the component voltage sources is exactly equal to two, and
- in the case of illumination of the first stack (ST1) with light (L) the light (L) is incident at the upper side on the surface (OB) on the first stack (ST1) and the size of the illuminated surface (OB) at the stack upper side substantially corresponds with the size of the area of the first stack at the upper side, and the first stack (ST1) has an overall thickness less than 12 µm, and
- at 300 K the first stack (ST1) has a source voltage (VQ1) of more than 2.2 volts insofar as the first stack (ST1) is irradiated with light (L) and wherein in light incidence direction from the upper side of the first stack (ST1) towards the lower side of the stack the total thickness of the p and n absorption layers of a semiconductor diode increases from the uppermost semiconductor diode (D1) towards the lowermost semiconductor diode (D2), and each p absorption layer of the semiconductor diode (D1, D2) is passivated by a p-doped passivation layer with a greater band gap than the band gap of the p absorption layer,
- the first stack (ST1) is arranged on a substrate (SUB) and the substrate (SUB) comprises a semiconductor material, and on the upper side of the first stack (ST1) a first voltage terminal (VSUP1) is formed as an encircling first metal contact (K1) in the vicinity of the edge (R) or as an individual contact area (K1) at the edge (R),
- an upper side (OS) of the substrate (SUB) is connected with the lowermost diode by material couple,
- the upper side (OS) of the substrate (SUB) has a larger surface than the area at the lower side of the first stack (ST1) so that an encircling step (STU) is formed in the vicinity of the lower side of the first stack (ST1) and
- a second voltage terminal (VSUP2) is formed as a whole-area metallic terminal contact (K2) at a lower side of the substrate (SUB).

2. Scalable voltage source (VQ) according to claim 1, **characterised in that** the component source voltages of the component voltage sources have a difference of less than 10% from one another.

3. Scalable voltage source (VQ) according to claim 1 or claim 2. **characterised in that** the semiconductor diodes (D1, D2) respectively comprise the same semiconductor material.

4. Scalable voltage source (VQ) according to any one of the preceding claims, **characterised in that** the first stack (ST1) has a plan area less than 2 mm² or less than 1 mm2.

5. Scalable voltage source (VQ) according to claim 4, **characterised in that** the plan area is formed to be rectangular.

6. Scalable voltage source (VQ) according to any one of the preceding claims, **characterised in that** a second stack (ST2) is formed and the first stack (ST1) and the second stack (ST2) are arranged near one another on a common carrier and the two stacks (ST1, ST2) are connected together in series so that the voltage source (VQ1) of the first stack (ST1) and the voltage source (VQ2) of the second stack (ST2) add together.

7. Scalable voltage source (VQ) according to any one of the preceding claims, **characterised in that** the semiconductor material and/or the substrate consists or consist of III-V materials.

8. Scalable voltage source (VQ) according to any one of the preceding claims, **characterised in that** the substrate comprises germanium or gallium arsenide.

9. Scalable voltage source (VQ) according to any one of the preceding claims, **characterised in that** a semiconductor mirror is formed below the lowermost semiconductor diode of the stack.

10. Scalable voltage source (VQ) according to any one of the preceding claims, **characterised in that** the semiconductor layers of the stack (ST1) comprise at the same time layers containing arsenide and layers containing phosphide.

11. Scalable voltage source (VQ) according to any one of the preceding claims, **characterised in that** the corner of the edge is at least 5 µm and at most 500 µm distant from the directly adjoining side surface of the stack.

12. Scalable voltage source (VQ) according to any one of the preceding claims, **characterised in that** in the case of at least one semiconductor diode an intrinsic layer is formed between the p absorption layer and n absorption layer,

13. Scalable voltage source (VQ) according to any one of the preceding claims, **characterised in that** the intrinsic layer is formed at the lowermost semiconductor diode.

14. Scalable voltage source (VQ) according to any one of the preceding claims. **characterised in that** the intrinsic layer is formed at all semiconductor diodes.

15. Scalable voltage source (VQ) according to any one of the preceding claims, **characterised in that** the two semiconductor diodes are arranged on a germanium substrate and the semiconductor diodes each comprise as absorption material an InGaAs compound lattice-matched to the Ge substrate.

## Revendications

1. Source de tension échelonnable (VQ), comprenant :
- un nombre N de sources de tension partielles qui se présentent sous la forme de diodes semi-conductrices connectées en série les unes aux autres, dans laquelle chacune des sources de tension partielles comprend une diode semi-conductrice (D1, 02) présentant une jonction p-n, dans laquelle la diode semi-conductrice (D1, D2) présente une couche d'absorption dopée p et la diode semi-conductrice (D1, D2) présente une couche d'absorption n, dans laquelle la couche d'absorption n est passivée par une couche de passivation dopée n qui présente une bande interdite plus grande que la bande interdite de la couche d'absorption n, et dans laquelle les tensions de source partielle des différentes sources de tension partielles présentent entre elles un écart inférieur à 20 %, et
- une diode tunnel (T1) qui est formée entre deux sources de tension partielles successives, dans laquelle la diode tunnel (T1) comprend plusieurs couches semi-conductrices qui présentent une bande interdite plus grande que la bande interdite des couches d'absorption p / n, et dans laquelle les couches semi-conductrices qui présentent une bande interdite plus grande sont respectivement constituées d'un matériau présentant une stoechiométrie modifiée et/ou présentant une autre composition d'éléments que les couches d'absorption p / n de la diode semi-conductrice (D1, D2),
- dans laquelle les sources de tension partielles et les diodes tunnels (T1) sont intégrées les unes aux autres de façon monolithique et forment ensemble un premier empilement (ST1) qui présente une face supérieure et une face inférieure, et dans laquelle le nombre N de sources de tension partielles est exactement égal à deux,
- dans laquelle, lorsque le premier empilement (ST1) est éclairé avec une lumière (L), la lumière (L) frappe la surface (OB) du premier empilement (ST1) sur la face supérieure et la taille de la surface éclairée (OB) sur la face supérieure de l'empilement correspond sensiblement à la taille de la surface du premier empilement sur la face supérieure, et dans laquelle le premier empilement (ST1) présente une épaisseur totale inférieure à 12 µm,
- dans laquelle, à 300 K, le premier empilement (ST1) présente une tension de source (VQ1) supérieure à 2,2 volts, pour autant que le premier empilement (STl) soit irradié par la lumière (L), et dans laquelle, dans la direction d'incidence de la lumière, à partir de la face supérieure du premier empilement (ST1) en direction de la face inférieure de l'empilement, l'épaisseur totale des couches d'absorption p et n d'une diode semi-conductrice augmente à partir de la diode semi-conductrice supérieure (D1) en direction de la diode semi-conductrice inférieure (D2), et dans laquelle chaque couche d'absorption p de la diode semi-conductrice (D1, D2) est passivée par une couche de passivation dopée p qui présente une bande interdite plus grande que la bande interdite de la couche d'absorption p,
- dans laquelle le premier empilement (ST1) est agencé sur un substrat (SUS) et le substrat (SUB) comprend un matériau semi-conducteur sur la face supérieure du premier empilement (ST1), et dans laquelle une première borne de tension (VSUP1) est formée en tant que un premier contact métallique périphérique (K1) dans le voisinage du rebord (R) ou en tant qu'unique surface de contact (K1) sur le rebord (R),
- dans laquelle une face supérieure (OS) du substrat (SUB) est connectée à la diode la plus basse par l'intermédiaire d'une liaison de matière,
- dans laquelle la face supérieure (OS) du substrat (SUB) présente une surface plus grande que la surface de la face inférieure du premier empilement (ST1), de telle sorte qu'un gradin périphérique (STU) soit formé dans le voisinage de la face inférieure du premier empilement (ST1) et que la face supérieure (OS) du substrat (SUB) présente une surface plus grande que la surface de la face inférieure du premier empilement (STl), et
- dans laquelle une seconde borne de tension (VSUP2) est formée en tant que contact de connexion métallique K2 sur la totalité de la surface d'une face inférieure du substrat (SUB).

2. Source de tension échelonnable (VQ) selon la revendication 1, **caractérisée en ce que** les tensions de source partielle des sources de tension partielles présentent entre elles un écart inférieur à 10 %.

3. Source de tension échelonnable (VQ) selon la revendication 1 ou la revendication 2, **caractérisée en ce que** les diodes semi-conductrices (01, 02) sont constituées chacune du même matériau semi-conducteur.

4. Source de tension échelonnable (VQ) selon l'une quelconque des revendications précédentes, **caractérisée en ce que** le premier empilement (ST1) présente une surface de base inférieure à 2 mm² ou inférieure à 1 mm².

5. Source de tension échelonnable (VQ) selon la revendication 4, **caractérisée en ce que** la surface de base est quadrangulaire.

6. Source de tension échelonnable (VQ) selon l'une quelconque des revendications précédentes, **caractérisée en ce qu'**un second empilement (ST2) est formé, **en ce que** le premier empilement (ST1) et le second empilement (ST2) sont agencés l'un à côté de l'autre sur un support commun, et **en ce que** les deux empilements (ST1, ST2) sont connectés l'un à l'autre en série de telle sorte que la tension de source (VQ1) du premier empilement (ST1) et la tension de source (VQ2) du second empilement (ST2) s'additionnent.

7. Source de tension échelonnable (VQ) selon l'une quelconque des revendications précédentes, **caractérisée en ce que** le matériau semi-conducteur et/ou le substrat sont constitués de matériaux III-V.

8. Source de tension échelonnable (VQ) selon l'une quelconque des revendications précédentes, **caractérisée en ce que** le substrat comprend du germanium ou de l'arséniure de gallium.

9. Source de tension échelonnable (VQ) selon l'une quelconque des revendications précédentes, **caractérisée en ce qu'**un miroir semi-conducteur est formé en dessous de la diode semi-conductrice la plus basse de l'empilement.

10. Source de tension échelonnable (VQ) selon l'une quelconque des revendications précédentes, **caractérisée en ce que** les couches semi-conductrices de l'empilement (ST1) comprennent à la fois des couches contenant de l'arséniure et des couches contenant du phosphure.

11. Source de tension échelonnable (VQ) selon l'une quelconque des revendications précédentes, **caractérisée en ce que** le bord du rebord est distant d'au moins 5 µm et d'au plus 500 µm de la face latérale immédiatement adjacente de l'empilement.

12. Source de tension échelonnable (VQ) selon l'une quelconque des revendications précédentes, **caractérisée en ce qu'**une couche intrinsèque est formée entre la couche d'absorption p et la couche d'absorption n pour au moins une diode semi-conductrice.

13. Source de tension échelonnable (VQ) selon la revendication 12, **caractérisée en ce que** la couche intrinsèque est formée sur la diode semi-conductrice la plus basse.

14. Source de tension échelonnable (VQ) selon la revendication 12, **caractérisée en ce que** la couche intrinsèque est formée sur la totalité des diodes semi-conductrices.

15. Source de tension échelonnable (VQ) selon l'une quelconque des revendications précédentes, **caractérisée en ce que** les deux diodes semi-conductrices sont agencées sur un substrat de germanium, et **en ce que** les diodes semi-conductrices présentent chacune comme matériau d'absorption un composé InGaAs dont le réseau est adapté au substrat de germanium.
